(19) Europäisches Patentamt
European Patent Office
Office européen des brevets

(11) **EP 2 073 342 A1**

(12) **EUROPÄISCHE PATENTANMELDUNG**

(43) Veröffentlichungstag:
24.06.2009 Patentblatt 2009/26

(51) Int Cl.:
*H02J 13/00* $^{(2006.01)}$ *G01R 21/133* $^{(2006.01)}$

(21) Anmeldenummer: 07024559.2

(22) Anmeldetag: 18.12.2007

(84) Benannte Vertragsstaaten:
AT BE BG CH CY CZ DE DK EE ES FI FR GB GR HU IE IS IT LI LT LU LV MC MT NL PL PT RO SE SI SK TR
Benannte Erstreckungsstaaten:
AL BA HR MK RS

(71) Anmelder: **Siemens Aktiengesellschaft**
**80333 München (DE)**

(72) Erfinder:
• **Neumann, Bernhard**
**90556 Cadolzburg (DE)**
• **Prölss, Manfred**
**92263 Ebermannsdorf (DE)**
• **Schumann, Gordon**
**91502 Erlangen (DE)**

(54) **Verfahren und Vorrichtung zur Ermittlung der elektrischen Wirkleistung von einem oder meheren Verbraucherabzweigen**

(57) Die Erfindung betrifft ein Verfahren und Vorrichtung zur Ermittlung der elektrischen Wirkleistung von Verbraucherabzweigen, wobei die Wirkleistung ausgehend von erfassten Strom- und Spannungswerten sowie einer zugehörigen synchronisierten Zeitinformation (t) ermittelt wird.

**Beschreibung**

Die Erfindung betrifft ein Verfahren zur Ermittlung der Wirkleistung eines oder mehrerer Verbraucherabzweige und eine zugehörige Vorrichtung.

Für die Stromverbrauchsmessung werden bekanntlich elektrische Zähler, insbesondere in Haushalten, eingesetzt, die nach dem Ferraris-Prinzip arbeiten und die die elektrische Energie bzw. Arbeit messen, d.h., die über einen Zeitraum aufintegrierte Wirkleistung. Es gibt auch Zähler, die dies elektronisch tun. Dabei besteht die Möglichkeit, die Effektivwerte von Strom $I_{eff}$ und Spannung $U_{eff}$ zu messen und den Leistungsfaktor cos φ bei sinusförmigem Verlauf aus der Phasenverschiebung von Strom und Spannung bei sinusförmigem Verlauf zu bestimmen. Die Wirkleistung lässt sich dann nach folgender Gleichung ermitteln:

$$P = U_{eff} \times I_{eff} \times \cos \varphi.$$

Motormanagementsysteme sollen nicht nur die Wirkleistung eines einzelnen Motors erfassen, sondern auch die Wirkleistung einer Gruppe von Motoren, die z.B. zentral gespeist werden. Dabei muss an unterschiedlichen, dem Einsatz der Motoren entsprechenden Stellen der Strom und Spannung erfasst werden, wobei trotz unterschiedlicher Laufzeiten bei der Übertragung der erfassten Strom- und Spannungswerte deren zeitlicher Bezug nicht verloren gehen darf.

Daher liegt der Erfindung die Aufgabe zugrunde, ein Verfahren zur Ermittlung der Wirkleistung eines oder mehrerer Verbraucherabzweige anzugeben, dass die Wirkleistungsermittlung auf besonders einfache Weise ermöglicht.

Außerdem besteht die Aufgabe, eine entsprechende Vorrichtung vorzuschlagen.

Die erste Aufgabe wird mit dem Verfahren mit den Merkmalen nach Anspruch 1 gelöst. Vorteilhafte Weiterbildungen des Verfahrens sind den Unteransprüchen 2 bis 5 zu entnehmen.

Die weitere Aufgabe wird durch eine Vorrichtung mit den Merkmalen nach Anspruch 6 gelöst. Vorteilhafte Weiterbildungen der Vorrichtung sind den Unteransprüchen 7 bis 10 zu entnehmen.

Ein Ausführungsbeispiel der Erfindung wird im Folgenden anhand einer Figur näher erläutert.

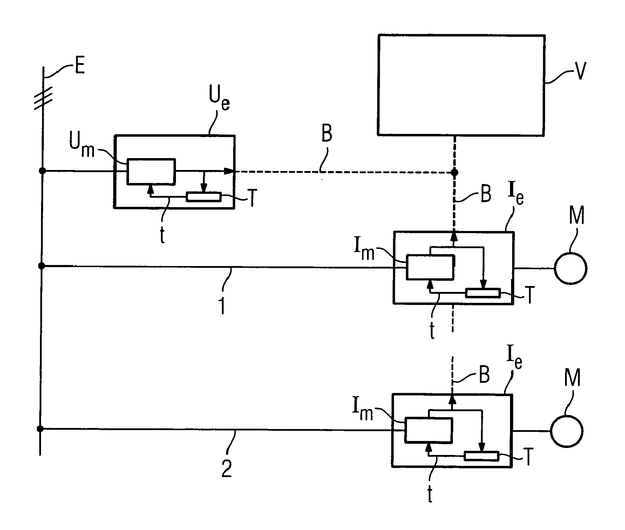

In der Figur ist eine Vorrichtung zur Ermittlung der Wirkleistung zweier Verbraucherabzweige 1 und 2 dargestellt, in denen jeweils als Verbraucher M ein Motor vorhanden ist. Beide Verbraucherabzweige 1 und 2 werden über eine zentrale Einspeisung E versorgt. Hierbei ist die Spannung für beide Verbraucherabzweige 1,2 nahezu gleich, so dass nur eine einzige Spannungsmessung für die Ermittlung der Wirkleistung beider Verbraucherabzweige 1 und 2 erforderlich ist. Dabei ist die Genauigkeitseinbuße meist vernachlässigbar. Somit sind für die Ermittlung der Wirkleistung eine Spannungserfassungseinheit $U_e$ und zwei Stromerfassungseinheiten $I_e$ vorgesehen, die allesamt grundsätzlich gleich aufgebaut sind und über ein Bussystem B als Datenübertragung mit einer Verarbeitungseinheit V in Verbindung stehen, die z.B. als Motormanagementsystem ausgeführt sein kann.

Die Spannungserfassungseinheit $U_e$ weist eine Spannungserfassung $U_m$ auf, mit der nach Transformation der Spannung auf einen für die Weiterverarbeitung geeigneten Spannungspegel einzelne Spannungswerte, z.B. durch Abtastung erfasst werden. Außerdem umfasst die Spannungserfassungseinheit $U_e$ einen Timer T, mit dem den Spannungswerten zugehörige Zeitstempel t erfasst werden. Dabei können die Zeitstempel t die gemessene absolute Zeit angeben.

In derselben Weise sind die Stromerfassungseinheiten $I_e$ jeweils mit einer Stromerfassung $I_m$ zur Erfassung einzelner Stromwerte, z.B. durch Abtastung und mit einem mit dieser in Verbindung stehenden Timer T ausgestattet. Diese Timer T erfassen den einzelnen Stromwerten zugehörige Zeitstempel t, die ebenfalls die absolute Zeit angeben können.

Die Timer T der Spannungsversorgungseinheit $U_e$ und, falls für jeden Verbraucherabzweig die Spannung gesondert gemessen wird, aller Spannungserfassungseinheiten $U_e$, sowie der Stromerfassungseinheiten $I_e$ sind untereinander synchronisiert. Dies bedeutet, dass sie für die Ermittlung der Zeitstempel t alle dieselbe zeitliche Basis, z.B. dieselbe absolute synchronisierte Zeitinformation haben. Somit ist es möglich, die einem bestimmten Zeitstempel t jeweils zugehörigen einzelnen Strom- und Spannungswerte und daraus den zugehörigen Leistungswert durch Multiplikation für den betreffenden Verbraucherabzweig 1 oder 2 zu ermitteln. Die Strom- und Spannungswerte werden von den Spannungs- $U_e$ und Stromerfassungseinheiten $I_e$ zusammen mit den zugehörigen Zeitstempeln t an die Verarbeitungseinheit V über das bestehende Bussystem B oder eine andere Datenübertragung übertragen. Die Verarbeitungseinheit V ermittelt zeitbezogene Leistungswerte und berechnet durch Mittelwertbildung in bekannter Weise die Wirkleistung P für jeden Verbraucherabzweig 1,2 und ggf. auch die Summe hiervon.

Die Besonderheit an der oben beschriebenen Vorrichtung und dem zugehörigen Verfahren zur Ermittlung der Wirkleistung besteht in der räumlichen und funktionalen Trennung der zur Erfassung erforderlichen Komponenten. Dies wird durch die Zuordnung von Zeitstempeln t für die erfassten Strom- und Spannungswerte ermöglicht. Außerdem kann auf diese Weise die elektrische Leistung in der räumlich und funktional abgesetzten Verarbeitungseinheit V erfolgen, ohne dass sich daraus Nachteile hinsichtlich der Genauigkeit oder hinsichtlich Anforderungen an die Übertragungsdynamik des eingesetzten Bussystems zur Kopplung der Komponenten ergeben. Als besonders vorteilhaft ist die Reduzierung der Anforderungen der Übertragungsgeschwindigkeit des eingesetzten Bussystems B zu nennen.

Vorzugsweise weisen die Spannungs- ($U_e$) und Stromerfassungseinheiten ($I_e$) Gehäuse gleicher Ausführung auf.

**Patentansprüche**

1. Verfahren zur Ermittlung der elektrischen Wirkleistung eines Verbraucherabzweigs (1 oder 2) in folgenden Schritten:

   a) es wird jeweils der zeitliche Verlauf des Stroms und der Spannung des Verbraucherabzweigs (1 oder 2) erfasst,
   b) die erfassten Strom- und Spannungswerte werden im Moment der Erfassung mit einer synchronisierten Zeitinformation (t) versehen,
   c) und aus diesen Daten werden in einer Verarbeitungseinheit (V) aufgrund der Zeitinformation (t) zeitlich zueinander gehörige Strom- und Spannungswerte zu Leistungswerten für die Ermittlung der elektrischen Wirkleistung verarbeitet.

2. Verfahren nach Anspruch 1, **dadurch gekennzeichnet, dass** der Strom und die Spannung nach Transformation durch entsprechende Wandler mit hoher Abtastrate abgetastet werden.

3. Verfahren nach Anspruch 1 oder 2 , **dadurch gekennzeichnet, dass** in derselben Weise die Wirkleistung mindestens eines weiteren Verbraucherabzweigs (2 oder 1) ermittelt wird.

4. Verfahren nach Anspruch 3, **dadurch gekennzeichnet, dass** die Spannung nur an einer einzigen Stelle erfasst wird, über die die Einspeisung (E) für die Verbraucherabzweige (1,2) erfolgt.

5. Verfahren nach einem der vorangehenden Ansprüche, **dadurch gekennzeichnet, dass** die Strom- und Spannungswerte sowie die zugehörige Zeitinformation (t) über eine Datenübertragung (B)an die Verarbeitungseinheit (V) übertragen werden.

6. Verfahren nach einem der vorangehenden Ansprüche, **dadurch gekennzeichnet, dass** die Synchronisation der Zeitinformation (t) über eine Datenübertragung (B) erfolgt.

7. Vorrichtung zur Ermittlung der elektrischen Wirkleistung eines Verbraucherabzweigs (1,2) mit einer Spannungs- ($U_e$) und einer Stromerfassungseinheit ($I_e$), einer Datenübertragung (B) und einer Verarbeitungseinheit (V), **dadurch gekennzeichnet, dass** die Spannungs- ($U_e$) und die Stromerfassungseinheit ($I_e$) jeweils eine Messwerterfassung (Um oder Im)und Mittel (T) zur Erfassung einer den jeweils erfassten Messwerten zugehörigen synchronisierten Zeitinformation (t) aufweisen.

8. Vorrichtung nach Anspruch 7, **dadurch gekennzeichnet, dass** als Mittel (T) zur Erfassung einer den jeweils erfassten Messwerten zugehörigen synchronisierten Zeitinformation synchronisierte Timer vorgesehen sind.

9. Vorrichtung nach Anspruch 7 oder 8, **dadurch gekennzeichnet, dass** als Datenübertragung (B) ein Bussystem vorgesehen ist.

10. Vorrichtung nach einem der vorangehenden Ansprüche, **dadurch gekennzeichnet, dass** mindestens eine weitere Spannungs-($U_e$) und eine weitere Stromerfassungseinheit ($I_e$) der genannten Art zur Ermittlung der Wirkleistung eines weiteren Verbraucherabzweigs (2,1) vorgesehen sind.

11. Vorrichtung nach einem der vorangehenden Ansprüche 7 bis 10, **dadurch gekennzeichnet, dass** zur Spannungserfassung nur eine einzige Spannungserfassungseinheit ($U_e$) für alle Verbraucherabzweige bei zentraler Einspeisung vorgesehen ist.

12. Vorrichtung nach einem der vorangehenden Ansprüche 7 bis 11, **dadurch gekennzeichnet, dass** die Verarbeitungseinheit (V) als ein Gerät zum Management mehrerer Verbraucherabzweige (1,2) ausgeführt ist.

**13.** Vorrichtung nach einem der vorangehenden Ansprüche 7 bis 12, **dadurch gekennzeichnet, dass** die Verbraucherabzweige (1,2) als Motorabzweige ausgeführt sind.

**Europäisches Patentamt**

**EUROPÄISCHER RECHERCHENBERICHT**

Nummer der Anmeldung

EP 07 02 4559

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 830 450 A (ABB TECHNOLOGY AG [CH]) 5. September 2007 (2007-09-05)<br><br>* Spalte 3, Zeile 37 - Spalte 4, Zeile 12 *<br>* Spalte 5, Zeile 55 - Spalte 7, Zeile 45; Abbildungen 1-3 *<br>* Zusammenfassung *<br>----- | 1-3, 5-10,12, 13 | INV. H02J13/00 G01R21/133 |
| X | EP 1 416 603 A (ABB RESEARCH LTD [CH]) 6. Mai 2004 (2004-05-06)<br><br>* Spalte 4, Zeile 46 - Spalte 7, Zeile 45; Abbildungen 1-3 *<br>* Zusammenfassung *<br>----- | 1-3, 5-10,12, 13 | |
| X | US 5 995 911 A (HART RONALD G [CA]) 30. November 1999 (1999-11-30)<br>* Spalte 11, Zeile 13 - Spalte 12, Zeile 17; Abbildung 4 *<br>* Spalte 14, Zeile 7 - Spalte 15, Zeile 25; Abbildung 5 *<br>* Spalte 18, Zeile 22 - Spalte 19, Zeile 44 *<br>* Zusammenfassung *<br>----- | 1,7 | |

-/--

RECHERCHIERTE SACHGEBIETE (IPC)

H02J
G01R

Der vorliegende Recherchenbericht wurde für alle Patentansprüche erstellt

| Recherchenort | Abschlußdatum der Recherche | Prüfer |
|---|---|---|
| München | 27. Mai 2008 | Bronold, Harald |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes Dokument

EPO FORM 1503 03.82 (P04C03)

**Europäisches Patentamt**

**EUROPÄISCHER RECHERCHENBERICHT**

Nummer der Anmeldung

EP 07 02 4559

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | SAITOH H ED - INSTITUTE OF ELECTRICAL AND ELECTRONICS ENGINEERS: "GPS synchronized measurement applications in japan" IEEE/PES TRANSMISSION AND DISTRIBUTION CONFERENCE AND EXHIBITION 2002 : ASIA PACIFIC. YOKOHAMA, JAPAN, OCT. 6 - 10, 2002; [IEEE/PES TRANSMISSION AND DISTRIBUTION CONFERENCE AND EXPOSITION], NEW YORK, NY : IEEE, US, Bd. 1, 6. Oktober 2002 (2002-10-06), Seiten 494-499, XP010631444 ISBN: 978-0-7803-7525-3 * das ganze Dokument * ----- | 1,7 | |
| X | LOREDANA CRISTALDI ET AL: "A Distributed System for Electric Power Quality Measurement" IEEE TRANSACTIONS ON INSTRUMENTATION AND MEASUREMENT, IEEE SERVICE CENTER, PISCATAWAY, NJ, US, Bd. 51, Nr. 4, 1. August 2002 (2002-08-01), XP011073942 ISSN: 0018-9456 * das ganze Dokument * ----- | 1,7 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| München | 27. Mai 2008 | Bronold, Harald |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 02 4559

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-05-2008

| Im Recherchenbericht angeführtes Patentdokument | | Datum der Veröffentlichung | Mitglied(er) der Patentfamilie | | Datum der Veröffentlichung |
|---|---|---|---|---|---|
| EP 1830450 | A | 05-09-2007 | US | 2007206644 A1 | 06-09-2007 |
| EP 1416603 | A | 06-05-2004 | CA | 2446876 A1 | 01-05-2004 |
|  |  |  | US | 2004090725 A1 | 13-05-2004 |
| US 5995911 | A | 30-11-1999 | US | 6236949 B1 | 22-05-2001 |

EPO FORM P0461

Für nähere Einzelheiten zu diesem Anhang : siehe Amtsblatt des Europäischen Patentamts, Nr.12/82